# EUROPÄISCHE PATENTSCHRIFT

(11) **EP 2 831 910 B1**
(45) Veröffentlichungstag und Bekanntmachung des Hinweises auf die Patenterteilung: **10.11.2021**
(21) Anmeldenummer: 13717727.5
(22) Anmeldetag: 26.03.2013
(51) Int. Cl.: H01L 21/67

(54) **VORRICHTUNG ZUM ENTFERNEN EINER BESCHICHTUNG VON EINEM SUBSTRAT UND VERFAHREN**
DEVICE FOR REMOVING A COATING FROM A SUBSTRATE AND METHOD
DISPOSITIF ET PROCÉDÉ D'ÉLIMINATION D'UN REVÊTEMENT D'UN SUBSTRAT

(30) Priorität: 29.03.2012 DE 102012102740; 17.04.2012 DE 102012103330
(43) Veröffentlichungstag der Anmeldung: 04.02.2015
(73) Patentinhaber: Solar-Semi GmbH, 78315 Radolfzell (DE)
(72) Erfinder: MUFFLER, Pirmin, 78359 Orsingen-Nenzingen (DE)
(74) Vertreter: Patentanwälte und Rechtsanwalt Weiß, Arat & Partner mbB
(86) Internationale Anmeldenummer: PCT/EP2013/056333
(87) Internationale Veröffentlichungsnummer: WO 2013/144108

(56) Entgegenhaltungen:
- US-A- 4 036 615
- US-A- 5 608 943
- US-A1- 2002 088 393
- US-A1- 2006 169 202
- US-A1- 2007 169 793

## Beschreibung

### TECHNISCHES GEBIET

Die Erfindung betrifft eine Vorrichtung zum Entfernen einer Beschichtung von einem Substrat nach dem Oberbegriff des Anspruchs 1 sowie ein Verfahren nach dem Oberbegriff des Anspruchs 2.

### STAND DER TECHNIK

Substrate, beispielsweise Wafer oder Platinen werden für unterschiedliche Anwendungen oder Bearbeitungsschritte beschichtet. Meist erfolgt diese Beschichtung über die ganze Oberfläche des Substrats. Für bestimmte Anwendungsfälle muss ein Randbereich des Substrats frei von der Beschichtung sein. Nachteiligerweise ist es sehr aufwändig, ein Substrat nur bereichsweise und trotzdem sehr gleichmäßig zu beschichten.

In diesem Zusammenhang wird auf die US 5,608,943 hingewiesen. Dort ist eine Vorrichtung zum Entfernen einer Beschichtung offenbart, bei der eine Waschdüse zum Ausbringen eines flüssigen Mediums zum Einsatz kommt. Weiter wird auf die US 2006/169202 A1 hingewiesen, welche ebenfalls eine Vorrichtung zum Entfernen einer Beschichtung aufzeigt, wobei eine Düse zum Ausbringen eines flüssigen Mediums offenbart ist.

Ausserdem wird auf die US 4,036,615 A hingewiesen, welche eine Luftentwässerungsanlage beschreibt, bei der die Luftfeuchtigkeit durch Kondensation aus der Luft abgeschieden wird.
und die US 2002/088393 A1 hingewiesen, welche weitere eine weitere Vorrichtung offenbart, bei der eine Düse zum Aufbringen eines flüssigen Mediums offenbart ist.

In diesem Zusammenhang wird ausserdem auf die US 2007/0169793 A1 hingewiesen, welche eine Düse offenbart, bei der mittig ein Lösemittel und um den Lösemittelstrahl ein Führungsmedium aus der Düse geblasen wird.

### BESCHREIBUNG DER ERFINDUNG

Aufgabe der Erfindung ist es, eine Vorrichtung sowie ein Verfahren bereitzustellen, mit dem eine Beschichtung eines Substrats in einem bestimmten Bereich des Substrats präzise entfernt werden kann, ohne das Substrat zu beschädigen.

Zur Lösung der Aufgabe führen die Merkmale der Ansprüche 1 und 2.

Erfindungsgemäß umfasst eine Vorrichtung zum Entfernen einer Beschichtung, insbesondere Fotolack von einem Substrat in zumindest einem Bereich des Substrats eine Düse.

Erfindungsgemäß ist die Düse geeignet einen Strahl Lösungsmedium auszubringen.

In typischen Ausführungsbeispielen handelt es sich bei der Beschichtung um Fotolack. Die Beschichtung kann noch flüssig sein oder bereits getrocknet sein. Vorzugsweise wird das verwendete Lösungsmedium an die zu entfernende Beschichtung angepasst. Dadurch ergibt sich der Vorteil, dass mit der Vorrichtung unterschiedliche Beschichtungen entfernt werden können.

Besonders bevorzugt soll mit dem Strahl die Beschichtung in einem Randbereich des Substrats entfernt werden. Durch die Verwendung der Düse ergibt sich der Vorteil, dass eine Breite des zu entfernenden Bereichs dadurch bestimmt werden kann, wie nahe oder wie weit entfernt von einer Kante des Substrats die Düse geführt wird. Vorzugsweise soll von einer Kante aus ein Bereich zwischen 1 mm bis 30 mm entfernt werden. Des weiteren ist vorteilhaft, dass ein Entfernen der Beschichtung ohne Beschädigung des Substrats möglich ist. Des weiteren ist vorteilhaft, dass durch geeignete Wahl des Lösungsmittels und Druck des Strahles die Beschichtung vollständig entfernt werden kann.

Erfindungsgemäß ist die Düse geeignet den Lösungsmediumsstrahl so auszubringen, dass er in einem Druckluftstahl geführt ist. Dadurch ergibt sich der Vorteil, dass der Lösungsmediumsstrahl sehr stabil ist. Dadurch wird das präzise Entfernen eines Bereichs der Beschichtung auf dem Substrat möglich.

Erfindungsgemäß umfasst die Vorrichtung eine Absaugeinrichtung. Dadurch ergibt sich der Vorteil, dass Lösungsmedium, das von dem Substrat abprallt, nicht in die Umwelt gelangt, sondern abgesaugt, aufbereitet und unter Umständen wieder verwertet werden kann. Ein weiterer Vorteil der Absaugeinrichtung ist, dass auch die von dem Substrat abgetragene Beschichtung abgesaugt werden kann und nicht in die Umwelt gelangt.

Erfindungsgemäß umfasst die Absaugeinrichtung eine Trennvorrichtung. Dadurch ergibt sich der Vorteil, dass aus dem abgesaugtem Medium aus abgetragener Beschichtung und dem Lösungsmedium von der Druckluft getrennt werden können. Erfindungsgemäß ist als Trennvorrichtung ein Kondensator eingesetzt. Dadurch ergibt sich der Vorteil, dass das Trennen von Druckluft und den darin enthaltenen Stoffen auf einfache Art und Weise möglich ist.

Erfindungsgemäß umfasst die Absaugeinrichtung oder die Trennvorrichtung einen Kondensator. Besonders bevorzugt wird als Kondensator eine Prallwand eingesetzt. Dabei ist die Prallwand geeignet zum zumindest teilweisen kondensieren des abgesaugten Mediums.

Besonders bevorzugt wird das abgesaugte Medium auf die Prallwand geleitet und an dieser schlagartig abgebremst. Dadurch kondensiert das Medium. Vorzugsweise kann das an der Prallwand kondensierte Medium über einen Ablauf einer Aufbereitungseinrichtung zugeführt werden. Dadurch ergibt sich der Vorteil, dass das Lösungsmedium wieder verwertet werden kann.

Erfindungsgemäß umfasst die Vorrichtung eine Aufnahme. Dabei ist die Aufnahme geeignet zum Halten, Positionieren, Verfahren und/oder Ausrichten des Substrats gegenüber der Düse und/oder dem Lösungsmediumsstrahl. Dadurch ergibt sich der Vorteil, dass eine Relativbewegung zwischen Lösungsmediumsstrahl und Substrat auf einfache Art und Weise ermöglicht werden kann. Des weiteren ist vorteilhaft, dass der komplizierte Aufbau aus Düse und Absaugeinrichtung nicht bewegt werden muss.

Vorzugsweise umfasst die Aufnahme eine Einrichtung zum Flachziehen des Substrats auf der Auflage. Bevorzugt umfasst die Vorrichtung zum Flachziehen zumindest eine Ansaugdüse. Vorzugsweise umfasst die Vorrichtung eine Mehrzahl von Ansaugdüsen. Besonders bevorzugt sind die Ansaugdüsen so angeordnet, dass sie an den Randbereichen des Substrats wirken. Dadurch ergibt sich der Vorteil, dass das Substrat vor allem in den Bereichen, an denen die Beschichtung entfernt werden soll korrekt positioniert ist und ein wirkendes Substrat verhindert wird. Dies ist besonders vorteilhaft, da bei einem gebürtigen Substrat eine Beschädigung des Substrats und/oder eine nicht ausreichende Abtragung der Beschichtung vorkommen könnte.

Erfindungsgemäß umfasst die Vorrichtung eine Ausrichteinheit. Dabei ist die Aussichtseinheit geeignet das Substrat korrekt zu Düse beziehungsweise dem Lösungsmediumsstrahl auszurichten. Vorzugsweise ermittelt und/oder korrigiert die Aussichtseinheit die korrekte Lage des Substrats auf Grundlage einer Mehrpunktmessung. Vorzugsweise wird eine Zweipunktmessung durchgeführt.

In typischen Ausführungsbeispielen umfasst die Ausrichteinheit einen Sensor der zu den Messungen verfahren wird. Alternativ umfasst die Ausrichteinheit dazu zwei Sensoren beziehungsweise eine Mehrzahl von Sensoren. Vorzugsweise kann dann auf ein Verfahren verzichtet werden.

Erfindungsgemäß umfasst die Vorrichtung eine Erfassungseinrichtung, geeignet zum Erfassen einer Kontur des Substrats. Vorzugsweise handelt es sich bei der Einrichtung um eine Kamera, oder einen Abstandssensor. Dadurch ergibt sich der Vorteil, dass die Kontur eines Substrats erkannt werden kann. Dies ist besonders vorteilhaft, weil dann auch Substrate mit einer unregelmässigen Kontur entlackt werden können. Ferner ist vorteilhaft, dass auch die Lage und der Verlauf der Kontur erkennbar ist.

Das Problem beim Entfernen einer Beschichtung in einem Randbereich insbesondere beim Entlacken von runden, kreisscheibenförmigen Substraten ist, dass diese meist an ihrem Umfang eine Unregelmässigkeit, wie eine sog Flat, also einen fehlenden Kreisbogenabschnitt oder einen Notch, also ein Einkerbung aufweisen. Wenn ein rundes Substrat zum Entfernen einer Beschichtung in einem Randbereich einfach unter einem Lösungsmediumsstrahl beziehungsweise einer Düse durchgedreht wird, ergibt sich das Problem, dass an dem Flat oder an dem Notch, deren Konturen ja nicht auf dem Kreisumfang liegen, die Beschichtung nicht entfernt werden kann. Dies ist besonders problematisch, weil sich an den Rand durch die Drehbewegung des runden Substrats beim Beschichten eine Wulst ergibt. Diese Wulst ist für die folgenden Bearbeitungsschritte störend.

Erfindungsgemäß umfasst die Vorrichtung einen Antrieb, der geeignet ist, die Aufnahme rotierend anzutreiben. Damit ist der Antrieb auch geeignet, ein Substrat, das auf der Aufnahme liegt, zu rotieren. Vorzugsweise wird das Substrat in einer Ebene rotiert, die im Wesentlichen senkrecht zu einer Richtung des Lösungsmediumsstrahls verläuft. Dadurch ergibt sich der Vorteil, dass zum Entfernen der Beschichtung entlang der kreisförmigen Kontur des Substrats die Aufnahme mit dem Substrat nur rotiert werden muss.

Ferner ist vorteilhaft, dass das Substrat, durch Rotieren die Aufnahme auf einfache Art und Weise an der Erfassungseinrichtung vorbei geführt werden kann. Vorzugsweise ist die Erfassungseinrichtung zum Erfassen einer Kontur dabei so über einem Randbereich des Substrats positioniert, dass die Vorrichtung, wenn das Substrat gedreht wird, den Verlauf der Kontur erfassen kann.

Erfindungsgemäß umfasst die Vorrichtung einen Linearantrieb und/oder eine Linearführungseinrichtung, geeignet die Aufnahme linear zu der Düse zu verschieben.

Vorzugsweise ist der Linearantrieb und/oder die Linearführungseinrichtung geeignet, die Aufnahme, vorzugsweise mit dem Substrat so unter oder zu der Erfassungseinrichtung zu bewegen, dass diese die gesamte Kontur des Substrats erfassen kann, wenn das Substrat unter der Erfassungseinrichtung rotiert wird.

Vorzugsweise ist der Linearantrieb und/oder die Linearführung geeignet die Aufnahme mit dem Rotationsantrieb zwischen der Erfassungseinrichtung und der Düse zu verfahren.

Noch bevorzugter ist der Linearantrieb und/oder die Linearführung auch geeignet die Aufnahme und damit auch das Substrat so unter der Düse beziehungsweise den Lösungsmediumsstrahl zu positionieren, dass durch Rotieren der Aufnahme eine Beschichtung in den Randbereichen des Substrats entfernt werden kann.

Besonders bevorzugt, können beide Antriebe, also der Rotationsantrieb und der Linearantrieb gleichzeitig betrieben werden. Dadurch ergibt sich der Vorteil, dass die Aufnahme und damit auch das Substrat nicht nur rotierend oder nur linear bewegt werden kann. Durch Überlagerung der beiden Bewegungsrichtungen kann die Aufnahme und damit auch das Substrat entlang allen möglichen Freiformen bewegt werden. Dies ist vorteilhaft, weil das Substrat dann so unter der Düse bzw. dem Lösungsmediumsstrahl hindurch bewegt werden kann, dass entlang der Kontur des Flats und des Notchs eine Beschichtung entfernt werden kann. Dadurch ergibt sich für die vorliegende Vorrichtung der Vorteil, dass in einem Arbeitsschritt eine Beschichtung in einem Randbereich eines Substrats vollständig entfernt werden kann, auch wenn dieses Unregelmäßigkeiten, wie beispielsweise einen Flat oder einen Notch aufweisen.

Gesondert wird Schutz beansprucht, für ein Verfahren zum Entfernen einer Beschichtung, insbesondere Fotolack von einem Substrat in zumindest einem Bereich des Substrats, wobei das Substrat erst ausgerichtet wird und dann eine Lösungsmedium auf das Substrat ausgebracht wird.

Erfindungsgemäß wird zum Ausrichten das Substrat flachgezogen und dann das Substrat und/oder die Düse in einem Abstand zu einem Mittelpunkt der Düse in Abhängigkeit einer gewünschten Breite des Bereichs in dem die Beschichtung entfernt werden soll, positioniert. Dadurch ergibt sich der Vorteil, dass mit einer Vorrichtung unterschiedlicher Bereiche auf einfache Art und Weise entfernt werden können.

Erfindungsgemäß wird zum Aufbringen eines Lösungsmittels auf das Substrat der Lösungsmediumsstrahl in einem Druckluftstrahl geführt. Weiter wird dabei eine Relativbewegung zwischen dem Substrat und den Lösungsmediumsstrahl ausgeführt. Dadurch ergibt sich der Vorteil, dass auf sehr einfache Art und Weise ein Entfernen der Beschichtung möglich ist.

Erfindungsgemäß umfasst ein Verfahren zum Entfernen einer Beschichtung, insbesondere Fotolack von einem im Wesentlichen kreisförmigen Substrat in zumindest einem Bereich des Substrats, den Schritt: Erfassen einer Kontur eines Substrats. Vorzugsweise werden dabei die Form einer Unregelmässigkeit, wie Flat oder Notch erfasst. Besonders bevorzugt wird die Lage der Unregelmäßigkeit erfasst. Erfindungsgemäß wird das Substrat in Abhängigkeit einer gewünschten Breite des Bereichs in dem die Beschichtung entfernt werden soll zu einem Lösungsmediumsstrahl positioniert. Besonders bevorzugt wird das Substrat in Abhängigkeit der erfassten Kontur so zu dem Lösungsmediumsstrahl verfahren, dass die Beschichtung in einem Randbereich der erfassten Kontur entfernt wird. Dadurch ergibt sich der Vorteil, dass an den Rändern des Substrats, die nicht auf dem Kreisumfang liegen, ebenfalls ein Entfernen der Beschichtung möglich ist. Dies ist besonders wichtig, da sich am Rand des Substrats meist eine Wulst aus Beschichtungsmaterial bildet, die für die weitere Bearbeitung störend ist.

Vorzugsweise, wird das Substrat dazu unter dem Lösungsmediumsstrahl gedreht und an den Positionen der Unregelmäßigkeiten, über eine zusätzliche lineare Bewegung, die mit der Rotationsbewegung überlagert wird, entlang der Kontur der Unregelmäßigkeit durch den Lösungsmediumsstrahl geführt.

### KURZE BESCHREIBUNG DER FIGUREN

Nachfolgend wird die Erfindung anhand der beiliegenden Zeichnung näher beschrieben, diese zeit in ihren Figuren :
Figur 1 zeigt eine schematische Darstellung einer perspektivischen Ansicht einer erfindungsgemässen Vorrichtung zum Entfernen einer Beschichtung von einem Substrat;
Figur 2 zeigt eine schematische Darstellung einer Seitenansicht einer erfindungsgemässen Vorrichtung nach Figur 1 mit einem Substrat;
Figur 3 zeigt eine schematische Darstellung einer Schnittansicht eine Absaugeinrichtung der erfindungsgemässen Vorrichtung zum Entfernen einer Beschichtung von einem Substrat nach Figur 1;
Figur 4 eine schematische Darstellung einer Seitenansicht eines weiteren Ausführungsbeispiels einer erfindungsgemässen Vorrichtung, insbesondere zum Entfernen einer Beschichtung in einem Randbereich bei einem runden Substrat;
Figur 5 eine schematische Darstellung eine Draufsicht der Vorrichtung, insbesondere zum Entfernen einer Beschichtung in einem Randbereich bei einem runden Substrat nach Figur 4;
Figur 6 zeigt eine schematische Darstellung eines kreisförmigen Wafers mit einem Flat;
Figur 7 zeigt eine schematische Darstellung eines kreisförmigen Wafers mit einem Notch.

### AUSFÜHRUNGSBEISPIEL

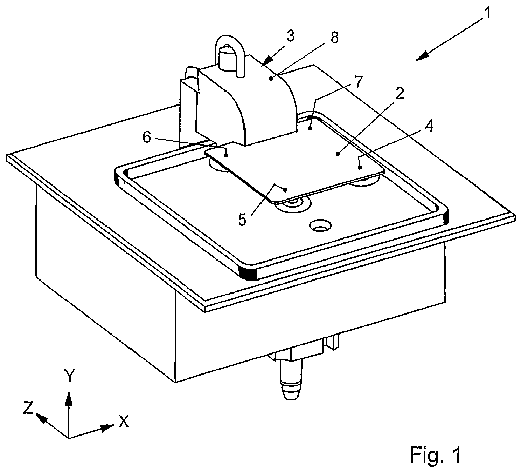

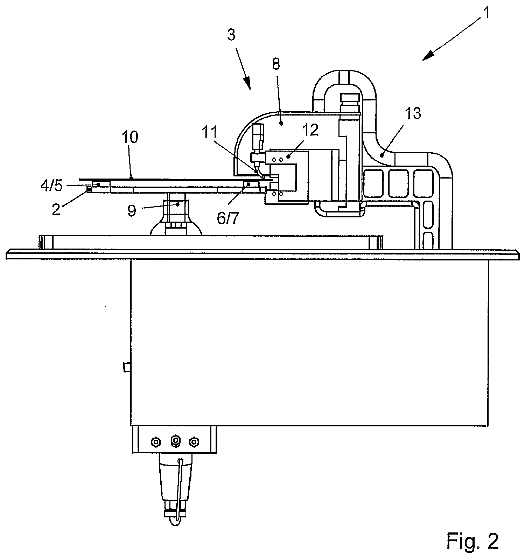

Figuren 1 und 2 zeigen eine erfindungsgemäßen Vorrichtung 1 zum Entfernen einer Beschichtung, insbesondere Fotolack von einem Substrat 10, in zumindest einem Bereich des Substrats 10.

Die Vorrichtung 1 umfasst eine Aufnahme 2 und eine Entfernungseinrichtung 3.

Die Aufnahme 2 dient zum Halten, Positionieren und/oder Ausrichten des Substrats 10.

Beispiele für mögliche Substrate sind: runde Wafer, rechteckige Wafer, quadratische Wafer, Dünnschicht Platten, Platinen od. dgl..

Im vorliegenden Ausführungsbeispiel ist die Aufnahme 2 als quadratische Platte ausgebildet. Die Aufnahme 2 ist gegen über der Entfernungseinrichtung 3 verfahrbar. Vorzugsweise umfasst die Aufnahme eine Verstelleinrichtung 9. Bevorzugt ist die Verstelleinrichtung 9 geeignet, die Aufnahme 2 in einer X-Z-Ebene zu verfahren. Vorzugsweise ist die Verstelleinrichtung 9 geeignet die Aufnahme 2 in einer Y- Richtung zu verstellen. Dies ist besonders vorteilhaft, wenn beispielsweise ein Abstand zwischen der Entfernungseinrichtung 3 und die Aufnahme 2 verändert werden soll.

In nicht dargestellten Ausführungsbeispielen umfasst die Entfernungseinrichtung ein Verstelleinrichtung, geeignet die Verstelleinrichtung in einer X-Z-Ebene und/oder in Y-Richtung zu verfahren.

Desweiteren umfasst die Aufnahme 2 eine Mehrzahl von Ansaugdüsen 4, 5, 6 und 7. die Ansaugdüsen 4, 5, 6, und 7 sind im Wesentlichen in einem Bereich der Ecken der der Aufnahme 2 angeordnet. Die Ansaugdüsen 4, 5, 6 und 7 dienen dazu das Substrat 10, das auf die Aufnahme 2 gelegt ist, anzusaugen und flach zu ziehen. Dadurch soll verhindert werden, dass das Substrat gewölbt auf der Aufnahme liegt. Dazu sind die Ansaugdüsen 4, 5, 6 und 7 mit einer nicht dargestellten Unterdruckquelle verbunden.

Die Entfernungseinrichtung 3 hat die Aufgabe ein Lösungsmedium auf das Substrat 10, das auf der Aufnahme 2 liegt, auszubringen, um eine Beschichtung des Substrats 10 in zumindest einem Bereich des Substrats 10 zu entfernen. Vorzugsweise soll Fotolack in einem Randbereich des Substrats 10 entfernt werden. Als Lösungsmedium kann geeignetes Lösungsmittel oder kleine Partikel, die abrasiv wirken, verwendet werden.

Desweiteren hat die Entfernungseinrichtung 3 die Aufgabe das Lösungsmedium und/oder die von dem Substrat 10 entfernte Beschichtung abzusaugen. Dazu umfasst die Entfernungseinrichtung 3 eine Haube 8. Die Haube 8 dient als Schutzeinrichtung. Vorzugsweise schützt die Haube 8 das Innenleben der Entfernungseinrichtung 3. Desweiteren dient die Haube 8 als Absaughaube.

Die Vorrichtung 1, insbesondere die Entfernungseinrichtung 3 umfasst eine Düse 11. Die Düse 11 ist geeignet zum Ausbringen eines Lösungsmediums. Die Düse 11 ist geeignet, das Lösungsmedium als Strahl auszubringen. Erfindungsgemäß ist die Düse 11 geeignet den Lösungsmediumsstrahl mit Druckluft führen. Dazu ist die Düse bevorzugt mit einer Druckluftquelle verbunden. Die Düse 11 weist dazu zwei Ausbringrohre, die ineinander geführt sind auf. Vorzugsweise wird aus dem Inneren Rohr das Lösungsmedium ausgebracht. Erfindungsgemäß wird der Druckluftstrahl aus dem äusseren Rohr ausgebracht. Diese Düse 11 ist mit einer nicht dargestellten Pumpe und einem nicht dargestellten Lösungsmediumreservoir verbunden. Bevorzugt ist die Pumpe geeignet das Lösungsmedium unter Druck auszubringen.

Des weiteren umfasst die Vorrichtung 1, insbesondere die Entfernungseinrichtung 3 eine Absaugeinrichtung 12. Die Absaugeinrichtung 12 ist über eine Leitung 13 mit einer nicht dargestellten Unterdruckquelle verbunden.

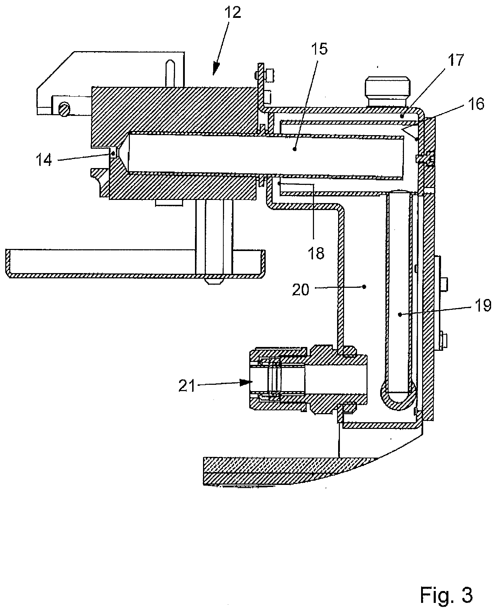

Figur 3 zeigt eine vergrößerte Schnittdarstellung der Absaugeinrichtung 12. Die Absaugeinrichtung 12 umfasst eine Ansaugöffnung 14. An die Ansaugöffnung 14 schließt ein Kanal 15 an. Der Kanal 15 führt in eine Kondenskammer 17. Die Kondenskammer 17 umfasst eine Prallwand 16. Die Kondenskammer 17 weist eine offene Seite 18 auf. Die offene Seite 18 ist gegenüberliegend zu der Prallwand 16 angeordnet.

An die Kondenskammer 17 schließt ein Ablauf 19 an. Der Ablauf 19 ist in der Nähe der Prallwand 16 angeordnet. Die offene Seite 18 führt in eine Kammer 20. Die Kammer 20 weist ein Ventil 21 auf.

Die Funktionsweise der vorliegenden Erfindung ist folgende:
Das Substrat 10 wird wie in Figur 2 gezeigt, auf die Aufnahme 2 beziehungsweise die Ansaugdüsen 4, 5, 6 und 7 gelegt. Die Ansaugdüsen 4, 5, 6 und 7 saugen das Substrat an, so dass es flach gezogen wird und nicht gewölbt ist.

Anschliessend wird die Aufnahme 2 mit dem Substrat 10 zur Düse 11 bzw der Entfernungseinrichtung 3 ausgerichtet. Dazu umfasst die Vorrichtung 1 eine nicht dargestellte Ausrichteinheit. Vorzugsweise ist die Ausrichteinheit geeignet über eine Zwei-Punkt-Detektion festzustellen, ob das Substrat korrekt und gerade liegt

Wenn das Substrat 10 korrekt zu Düse 11 ausgerichtet ist, wird die Düse 11 an einem Rand des Substrats 10 positioniert. In Abhängigkeit der Breite des Bereichs in dem die Beschichtung entfernt werden soll, wird das Zentrum der Düse 11 gegenüber dem Substrat 10 positioniert.

Anschliessend wird aus der Düse 11 ein Lösungsmediumsstrahl ausgebracht, der in einen Druckluftstrahl geführt ist.

Die Aufnahme 2 wird mit dem Substrat 10 unter der Düse 11 hindurch bewegt. Deshalb ist das korrekte Ausrichten und flachziehen des Substrats so wichtig. Wenn das Substrat jetzt schief liegen würde oder gewölbt wäre, würde die Beschichtung nicht gleichmässig und nicht im gewünschten Bereichentfernt werden. Weiter wäre bei einem Substrat, das sich wölbt problematisch, dass unter Umständen zuviel oder auch zuwenig Material in Y-Richtung entfernt werden würde.

Wenn das Substrat 10 mit einer Ecke unter der Düse 11 angekommen ist, wird die Aufnahme 2 mit dem Substrat 10, gedreht und der Vorgang wiederholt. Diese Schritten werden so lange wiederholt, bis alle gewünschten Ränder und/oder Seiten des Substrats 10 bearbeitet sind.

Während des Ausbringens des Lösungsmediums aus der Düse 11 wird gleichzeitig mit der Absaugeinrichtung 12 das ausgebrachte Lösungsmedium, das vom Substrat 10 zurückprallt und/oder die vom Substrat abgelöste Beschichtung abgesaugt.

Das abgesaugte Flüssigkeits- und/oder Partikel-Gasgemisch gelangt durch eine Absaugöffnung 14 in einen Kanal 15. Über den Kanal 15 wird das abgesaugte Flüssigkeits- und/oder Partikel-Gasgemisch in die Kondenskammer 17 geführt und an der Prallwand 16 der Kondenskammer schlagartig abgebremst.

Dadurch kondensiert die Flüssigkeit an der Prallwand 16. Über den Ablauf 19 wird das kondensierte Lösungsmedium einer Filter- oder Aufbereitungseinrichtung zugeführt.

Die gasförmigen Anteile des abgesaugten Mediums werden über die offene Seite 18 der Kondenskammer 17 in die Kammer 20 gesaugt und über das Ventil 21 mit der nicht dargestellten Druckluftquelle abgesaugt.

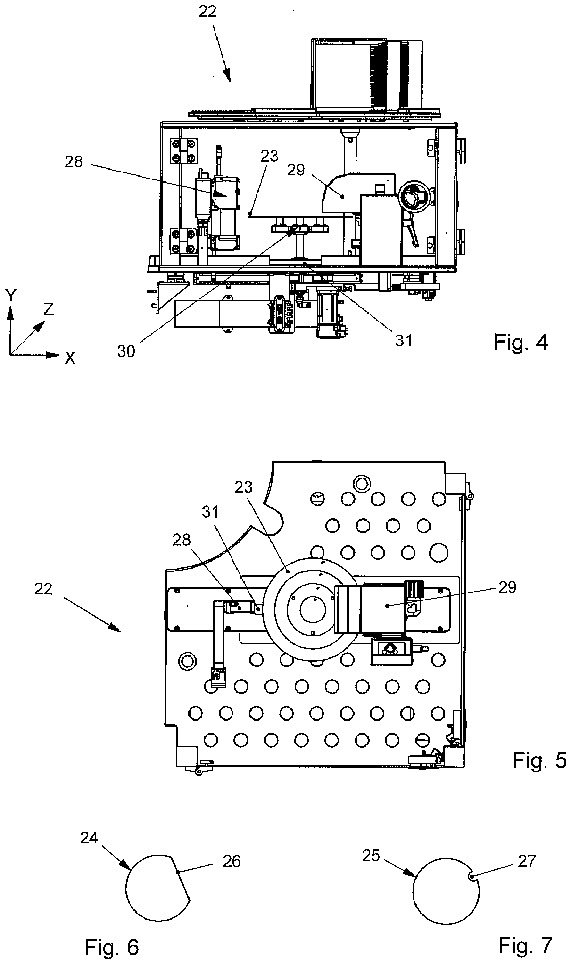

Die Figur 4 zeigt ein weiteres Ausführungsbeispiel einer Vorrichtung 22 zum Entfernen einer Beschichtung von einem Substrat 24, 25, insbesondere einem runden Substrat 24, 25.

Die Figuren 6 und 7 zeigen zwei unterschiedliche Ausführungsbeispiele eines runden Substrats 24 und 25. Das runde Substrat 24 weist als Unregelmäßigkeit einen Flat 26 auf. Der Flat 26 entsteht dadurch, dass man von einer Kreisscheibe einen Kreisbogenabschnitt entfernt.

Das runde Substrat 25 weist einen Notch 27 auf. Bei dem Notch 27 handelt es sich um eine teilkreisförmige Ausnehmung oder eine Kerbe.

Die Vorrichtung 22 umfasst eine Erfassungseinrichtung 28. Diese umfasst bevorzugt eine Kamera oder einen Sensor, der geeignet ist eine Kontur eines Substrats zu erfassen.

Die Vorrichtung 22 umfasst eine Entfernungseinrichtung 29. Die Entfernungseinrichtung 29 ist im Wesentlichen analog zu der Entfernungseinrichtung 3 aufgebaut. Im vorliegenden Ausführungsbeispiel ist die Entfernungseinrichtung 29 feststehend ausgebildet.

Vorzugsweise sind die Entfernungseinrichtung 29 und die Erfassungseinrichtung 28 so voneinander beabstandet, dass diese nicht gleichzeitig im Eingriff bei einem Substrat sind. Dadurch ergibt sich der Vorteil, dass die Erfassungseinrichtung 28 möglichst wenig verschmutzt wird.

Die Vorrichtung 22 umfasst eine Aufnahme 30 mit einer Aufnahmeplatte.23. Die Aufnahme 30 bzw. die Aufnahmeplatte 23 ist geeignet zum Halten, Drehen und Positionieren eines der Substrate 24 oder 25.

Die Aufnahme 30 umfasst einen nicht dargestellten Rotationsantrieb. Dieser ist geeignet, die Aufnahme 30 und damit auch ein Substrat in einer Z-X-Ebene zu rotieren.

Die Vorrichtung 22 umfasst eine Linearführung 31. Die Linearführung 31 erstreckt sich zwischen der Erfassungseinrichtung 28 und der Entfernungseinrichtung 29.

Die Vorrichtung 22 umfasst einen nicht dargestellten Linearantrieb. Der Linearantrieb ist geeignet die Aufnahme 30 mit dem Rotationsantrieb, entlang der Linealführung 31 in X-Richtung zu verfahren.

Die Funktionsweise der Vorrichtung nach den Ausführungsbeispielen der Figuren 4 und 5 ist folgende:
Insbesondere zum Entlacken eines runden Substrats, beispielsweise das Substrat 24 oder das Substrat 25, wird dieses auf die Halteplatte 23 der Aufnahme 30 gelegt.

Dann wird die Aufnahme 30 entlang der Linearführung 31 mittels des Linearantriebs so zu der Erfassungseinrichtung 28 verfahren, dass mit der Erfassungseinrichtung eine Kontur des Substrats detektiert werden kann.

Wenn das Substrat 24, 25 positioniert ist, wird die Aufnahme 30 und damit auch das Substrat 24, 25 unter der Erfassungseinrichtung 28 in der X-Z Ebene gedreht. Dadurch kann mit der Erfassungseinrichtung 28 eine gesamte Umfangskontur des Substrats 24, 25 detektiert werden. Die Form und die Position eines Flats 26 oder eines Notchs 27 werden erfasst. Es wird die Form und die Lage der Unregelmäßigkeit erkannt oder detektiert.

Anschließend wird die Aufnahme 30 mit dem Substrat 24, 25 in X-Richtung, so zu der Entfernungseinrichtung 29 verfahren, dass diese eine Beschichtung in einem Randbereich des Substrats 24, 25 entfernen kann. Solange es sich dabei um den kreisförmigen Umfang des Substrats 24, 25 handelt, ist es ausreichend, die Aufnahme nur in der X-Z-Ebene zu drehen.

Wenn die unregelmäßigen Konturen 26 und 27 in den Bereich der Düse 32 bzw. des Lösungsmediumsstrahl kommen, wird die Aufnahme 27 bzw. das Substrat so in X-Richtung bewegt, das durch Überlagerung der Linearbewegung und der Rotationsbewegung das Substrat 24, 25 entlang seiner Konturen 26 und 27 unter der Düse 32 geführt wird. Dabei wird die Beschichtung in einem Randbereich entlang einer gesamten Kontur entfernt.

**Bezugszeichenliste**

| | | | |
|---|---|---|---|
| 1 | Vorrichtung | 22 | Vorrichtung |
| 2 | Aufnahme | 23 | Aufnahmeplatte |
| 3 | Entfernungseinrichtung | 24 | Substrat |
| 4 | Ansaugdüse | 25 | Substrat |
| 5 | Ansaugdüse | 26 | Flat |
| 6 | Ansaugdüse | 27 | Notch |
| 7 | Ansaugdüse | 28 | Erfassungseinrichtung |
| 8 | Haube | 29 | Entfernungseinrichtng |
| 9 | Verfahreinrichtung | 30 | Aufnahme |
| 10 | Substrat | 31 | Linearführung |
| 11 | Düse | 32 | Düse |
| 12 | Absaugeinrichtung | | |
| 13 | Leitung | | |
| 14 | Ansaugöffnung | | |
| 15 | Kanal | | |
| 16 | Prallwand | | |
| 17 | Kondenskammer | | |
| 18 | offene Seite | | |
| 19 | Ablauf | | |
| 20 | Kammer | | |
| 21 | Ventil | | |
| | | | |
| X | X-Richtung | | |
| Y | Y-Richtung | | |
| Z | Z-Richtung | | |

## Patentansprüche

1. Vorrichtung (1) zum Entfernen von einer Beschichtung, insbesondere Fotolack von einem Substrat (10, 24, 25) in zumindest einem Bereich des Substrats (10, 24, 25),
die Vorrichtung umfassend eine Düse (11, 32), geeignet einen Strahl eines Lösungsmediums auszubringen, eine Absaugeinrichtung (12) vorhanden ist, wobei die Absaugeinrichtung (12) eine Ansaugöffnung (14) umfasst und an die Ansaugöffnung (14) ein Kanal (15) anschliesst, wobei der Kanal (15) in eine Kondenskammer (17) führt, wobei die Kondenskammer (17) eine Prallwand (16) umfasst und eine offene Seite (18) aufweist, wobei die offene Seite (18) gegenüberliegend zu der Prallwand (16) angeordnet ist und an die Kondenskammer (17) ein Ablauf (19) anschliesst, wobei die offene Seite (18) in eine Kammer (20) führt und die Kammer (20) ein Ventil (21) aufweist, wobei
die Vorrichtung eine Ausrichteinheit umfasst, geeignet zum Ausrichten von Substrat (10) zu der Düse (11), wobei
die Vorrichtung ferner eine Erfassungseinrichtung (28) umfasst, geeignet zum Erfassen einer Kontur des Substrats (24, 25), wobei
die Vorrichtung ferner einen Rotationsantrieb umfasst, geeignet, eine Aufnahme (2,30) zu rotieren, **dadurch gekennzeichnet, dass** die Düse (11) geeignet ist, einen Lösungsmediumsstrahl auszubringen, der in einem Druckluftstrahl geführt ist, wobei die Düse (11) dazu zwei Ausbringrohre aufweist, die ineinander geführt sind, wobei aus dem inneren Rohr das Lösungsmedium ausgebracht wird und der Druckluftstrahl aus dem äußeren Rohr ausgebracht wird, wobei die Vorrichtung eine Aufnahme (2,30) umfasst, welche geeignet ist zum Halten, Positionieren, Verfahren und/oder Ausrichten des Substrats, wobei
die Vorrichtung ferner einen Linearantrieb und/oder eine Linearführung (31) umfasst, geeignet, die Aufnahme (2,30) linear zu der Düse zu verfahren.

2. Verfahren für eine Vorrichtung nach dem Anspruch 1 zum Entfernen einer Beschichtung, insbesondere Fotolack von einem Substrat (10) in zumindest einem Bereich des Substrats (10), **gekennzeichnet durch** die Schritte:
a) Ausrichten des Substrats (10), das Ausrichten umfassend
- Flachziehen des Substrats (10) und
- Positionieren von Substrat (10) und/oder Lösungsmediumstrahl zueinander in Abhängigkeit einer gewünschten Breite des Bereichs in dem die Beschichtung entfernt werden soll.
b) Aufbringen eines Lösungsmediumsstrahls auf das Substrat (10), das Aufbringen umfassend
- Führen des Lösungsmediumsstrahls in einem Druckluftstrahl;
- Ausführen einer Relativbewegung zwischen dem Substrat (10) und dem Lösungsmediumsstrahl;
das Verfahren umfassend ferner die Schritte:
- Erfassen einer Kontur eines Substrats (24, 25),
- Positionieren des Substrats (24, 25) zu dem Lösungsmediumsstrahl in Abhängigkeit einer gewünschten Breite des Bereichs in dem die Beschichtung entfernt werden soll;
- Verfahren des Substrats (24, 25) mittels der Aufnahme in Abhängigkeit der erfassten Kontur, so dass ein Randbereich des Substrats (24, 25) vollständig entlackt wird.

## Claims

1. Device (1) for the removal a coating, in particular a photoresist, from a substrate (10, 24, 25) in at least one area of the substrate (10, 24, 25), the device comprising
a nozzle (11, 32) suitable for emitting a jet of a solvent medium, a suction device (12) being present, the suction device (12) comprising an intake opening (14) and a channel (15) adjoining the suction opening (14), the channel (15) leading into a condensation chamber (17), the condensation chamber (17) comprising a baffle wall (16) and having an open side (18), the open side (18) being opposite the baffle wall (16) and a drain (19) adjoins the condensation chamber (17), wherein the open side (18) leads into a chamber (20) and the chamber (20) has a valve (21), wherein
the device comprises an alignment unit suitable for aligning substrate (10) to the nozzle (11), wherein
the apparatus further comprises a sensing device (28) adapted to sense a contour of the substrate (24, 25), wherein
the apparatus further comprises a rotation drive adapted to rotate a receptacle (2, 30),
**characterized in that**
the nozzle (11) is adapted to dispense a jet of solution medium guided in a jet of compressed air, the nozzle (11) having two discharge tubes for this purpose guided one inside the other, the solution medium being dispensed from the inner tube and the jet of compressed air being dispensed from the outer tube, the device comprising a receptacle (2, 30) adapted to hold, position, move and/or align the substrate, wherein
the device further comprises a linear actuator and/or a linear guide (31 ) adapted to move the receptacle linearly with respect to the nozzle.

2. Method for a device according to claim 1 for the removal of a coating, in particular of photoresist, from a substrate (10) in at least one area of the substrate (10), **characterized by** the following steps:
a) aligning the substrate (10), the alignment comprising
- flattening the substrate (10) and
- positioning the substrate (10) and/or the solvent jet relative to each other in dependence on a desired width of the area in which the coating is to be removed
b) applying a solution medium jet to the substrate (10), the application comprising
- guiding the solution medium jet in a jet of compressed air;
- effecting a relative movement between the substrate (10) and the solution medium jet;
the method further comprising the steps of:
- detecting a contour of a substrate (24, 25),
- positioning the substrate (24, 25) relative to the solution medium jet in dependence upon a desired width of the area in which the coating is to be removed;
- moving the substrate (24, 25) by means of the receptacle in dependence of the detected contour, so that an edge area of the substrate (24, 25) is completely stripped of paint.

## Revendications

1. Dispositif (1) permettant d'enlever un revêtement, en particulier une résine photosensible, d'un substrat (10, 24, 25) dans au moins une zone du substrat (10, 24, 25),
le dispositif comprenant une buse (11, 32) adaptée pour appliquer un jet d'un milieu solvant,
un appareil d'aspiration (12)
étant prévu, le dispositif d'aspiration (12) comprenant une ouverture d'aspiration (14) et un canal (15) se raccordant à l'ouverture d'aspiration (14), le canal (15) menant à une chambre de condensation (17), la chambre de condensation (17) comprenant une paroi de réflexion (16) et présentant un côté ouvert (18), le côté ouvert (18) étant disposé à l'opposé de la paroi de réflexion (16) et un drain (19) se raccordant à la chambre de condensation (17), le côté ouvert (18) menant à une chambre (20) et la chambre (20) présentant une vanne (21),
le dispositif comprenant une unité d'alignement adaptée pour aligner le substrat (10) avec la buse (11),
le dispositif comprenant en outre un appareil de détection (28) adapté pour détecter un contour du substrat (24, 25),
le dispositif comprenant en outre un entraînement rotatif adapté pour faire tourner un réceptacle (2, 30), **caractérisé en ce que** la buse (11) est adaptée pour appliquer un jet de milieu solvant, lequel est guidé dans un jet d'air comprimé, la buse (11) présentant à cet effet deux tubes d'évacuation qui sont guidés l'un dans l'autre, le milieu solvant étant évacué du tube intérieur et le jet d'air comprimé étant évacué du tube extérieur, le dispositif comprenant un réceptacle (2, 30), lequel est adapté pour maintenir, positionner, déplacer et/ou aligner le substrat, le dispositif comprenant en outre un entraînement linéaire et/ou un guide linéaire (31), lesquels sont adaptés pour déplacer le réceptacle (2, 30) de manière linéaire vers la buse.

2. Procédé destiné à un dispositif selon la revendication 1 permettant d'enlever un revêtement, en particulier une résine photosensible, d'un substrat (10) dans au moins une zone du substrat (10), **caractérisé par** les étapes :
a) d'alignement du substrat (10), l'alignement comprenant
- l'étirage à plat du substrat (10) et
- le positionnement du substrat (10) et/ou du jet de milieu solvant l'un par rapport à l'autre en fonction d'une largeur souhaitée de la zone dans laquelle le revêtement doit être enlevé ;
b) d'application d'un jet de milieu solvant sur le substrat (10), l'application comprenant
- le guidage du jet de milieu solvant dans un jet d'air comprimé ;
- l'exécution d'un mouvement relatif entre le substrat (10) et le jet de milieu solvant ;
le procédé comprenant en outre les étapes :
- de détection d'un contour d'un substrat (24, 25),
- de positionnement du substrat (24, 25) par rapport au jet de milieu solvant en fonction d'une largeur souhaitée de la zone dans laquelle le revêtement doit être enlevé ;
- de déplacement du substrat (24, 25) au moyen du réceptacle en fonction du contour détecté, de sorte qu'une zone de bord du substrat (24, 25) est complètement dévernie.
